Europäisches Patentamt

European Patent Office

Office européen des brevets

(11) Publication number: **0 548 551 A1**

# EUROPEAN PATENT APPLICATION

(21) Application number: **92119819.8**

(22) Date of filing: **20.11.92**

(51) Int. Cl.5: **H03K 19/094**, H03K 19/21, H03K 3/356

(30) Priority: **26.12.91 JP 343733/91**
**14.02.92 JP 27034/92**

(43) Date of publication of application:
**30.06.93 Bulletin 93/26**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Yamashina, Masakazu, c/o NEC**
**Corporation**
**7-1, Shiba 5-chome, Minato-ku**
**Tokyo(JP)**

(74) Representative: **Betten & Resch**
**Reichenbachstrasse 19**
**W-8000 München 5 (DE)**

(54) **Logic circuit having high speed low power consumption characteristic.**

(57) The logic circuit having a high speed low power consumption characteristic according to the present invention is constituted of a load circuit connected to a first power source, a differential pair circuit connected to the load circuit and including at least a differential pair of MOS transistors for effecting logic operation, and a constant-current source interposed between the differential pair circuit and a second power source. With the construction, constant current is caused to flow by the constant-current source. Consequently, even if the logic circuit is caused to operate with a high frequency, the power consumption thereof is held fixed. Meanwhile, the amount of current which flows through the load circuit and the constant-current source can be increased to raise the operation speed. Even if the current is increased in this manner, the differential pair circuit itself to which the input signal is inputted is not varied. Accordingly, the problem that the load capacitance of the MOS transistor which serves as the load increases does not occur. An EXOR/EXNOR circuit, a NAND/AND circuit, a NOR/OR circuit, a storage circuit, an inverted-output/positive-logic-output circuit or the like may be employed as the differential pair circuit.

F I G.3

EP 0 548 551 A1

## BACKGROUND OF THE INVENTION

### Field of the Invention

This invention relates to a logic circuit, and more particularly to a logic circuit which is low in power consumption and suitable for high speed operation.

### Description of the Prior Art

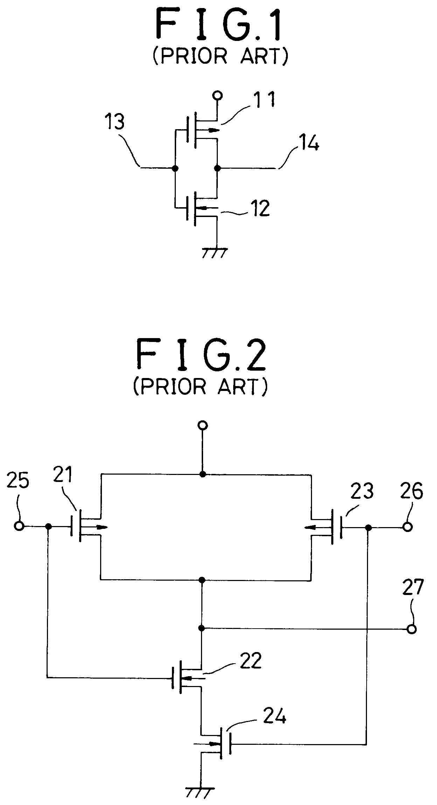

Fig. 1 shows an inverter circuit of the CMOS configuration which is employed widely in conventional digital circuits. The source of p-MOS transistor 11 is connected to a first power source having a higher potential than the ground potential, and the drain of p-MOS transistor 11 is connected to the drain of n-MOS transistor 12. The source of n-MOS transistor 12 is connected to the ground. Both MOS transistors 11 and 12 form a pair of CMOS circuits and invert an input signal inputted to input terminal 13 connected to the gates of MOS transistors 11 and 12. The drains of both MOS transistors 11 and 12 are connected to output terminal 14, and an output signal is outputted from output terminal 14.

Fig. 2 is a circuit diagram of a known NAND circuit which includes two pairs of the CMOS circuits shown in Fig. 1. Referring to Fig. 2, p-MOS transistor 21 and n-MOS transistor 22 as well as p-MOS transistor 23 and n-MOS transistor 24 separately constitute CMOS circuits. The sources of p-MOS transistors 21 and 23 are connected to a first power source while their drains are connected to output terminal 27, and the drain of n-MOS transistor 22 is connected to the drains of p-MOS transistors 21 and 23. The drain and the source of n-MOS transistor 24 are connected to the source of n-MOS transistor 22 and the ground, respectively.

Now, if input signal A is inputted from input terminal 25 to the gates of p-MOS transistor 21 and n-MOS transistor 22 while input signal B is simultaneously inputted from input terminal 26 to the gates of p-MOS transistor 23 and n-MOS transistor 24, then

when A = "0" and B = "0", transistors 21 and 23 conduct while transistors 22 and 24 non-conduct and output $\overline{AB}$ is "1";

when A = "0" and B = "1", transistors 21 and 24 conduct while transistors 22 and 23 non-conduct and output $\overline{AB}$ is "1";

when A = "1" and B = "0", transistors 22 and 23 conduct while transistors 21 and 24 non-conduct and output $\overline{AB}$ is "1"; and

when A = "1" and B = "1", transistors 22 and 24 conduct while transistors 21 and 23 non-conduct and output $\overline{AB}$ is "0",

where "0" represents the low voltage level, and "1" represents the high voltage level.

The operation speed of the conventional logic circuit described above depends upon the current supplying capacities of the individual MOS transistors to the capacitance of the load (not shown) connected to the logic circuit. Therefore, in order to increase the current flow to achieve high speed operation, the width of the gate of each MOS transistor is increased. However, if the widths of the MOS transistors in the entire apparatus are increased, then the capacitance of the gate itself which is a load to the logic circuit is also increased. Consequently, high speed operation cannot be achieved overall. Further, if the logic circuit is operated with a high frequency, then current which increases in proportion to the frequency flows through the logic circuit. Consequently, power consumption is increased. Meanwhile, the voltage of the power source is reduced in order to achieve improvement in the reliability of LSIs. However, with the conventional logic circuit shown in Fig. 2, the amount of current a MOS transistor can supply decreases in proportion to the square of the power source voltage. Consequently, there is the drawback that, if the power source voltage is reduced, the operation speed is decreased.

## SUMMARY OF THE INVENTION

It is an object of the present invention to provide a novel logic circuit which includes a load circuit, a differential pair circuit and a constant-current source combined so as to have a low power consumption characteristic suitable for high speed operation and a low power source voltage in order to eliminate the drawbacks of the conventional logic circuit described above. Here, a differential pair is defined as a combination of two MOS transistors wherein conduction of the MOS transistors is controlled by the difference between signals inputted to the gates of them.

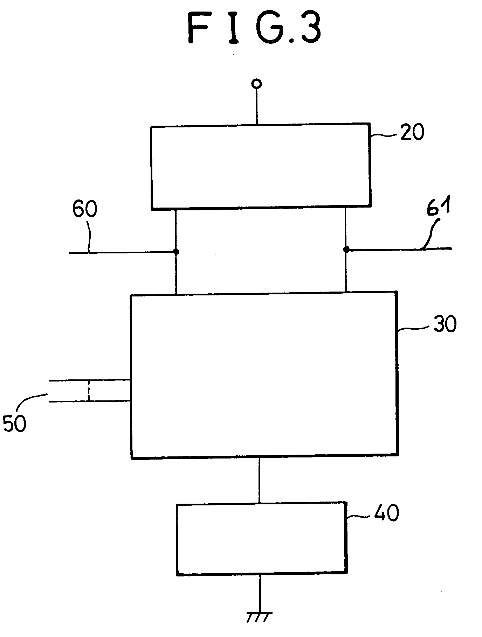

In order to attain the above object, the logic circuit of the present invention comprises, as shown in Fig. 3, load circuit 20 connected to a first power source, differential pair circuit 30 connected to load circuit 20 and including a differential pair of MOS transistors for effecting logic operation, and constant-current source 40 interposed between differential pair circuit 30 and a second power source. Differential pair circuit 30 has one or a plurality of input signal lines 50. Output signals are outputted through output signal lines 60 and 61. Load circuit 20 may be in the form of a current mirror circuit or a low resistance element.

With the construction, since the logic circuit of the present invention always causes a constant current to flow by constant-current source 40, the power consumption thereof is invariable and is not increased even during high frequency operation. Further, in order to raise the operation speed, the amount of current which flows through load circuit 20 and constant-current source 40 can be increased. Since differential pair circuit 30 to which input signal line 50 is connected remains as is in spite of the increase of the amount of current, the problem that the capacitance of the gate itself which serves as a load increases does not occur.

The above and other objects, features, and advantages of the present invention will become apparent from the following description when taken in conjunction with the accompanying drawings which illustrate preferred embodiments of the present invention by way of example.

BRIEF DESCRIPTION OF THE DRAWINGS

Fig. 1 is a circuit diagram of a known inverter of the CMOS configuration;
Fig. 2 is a circuit diagram of a conventional NAND circuit which uses the CMOS circuit of Fig. 1;
Fig. 3 is a block diagram showing the basic construction of the logic circuit of the present invention;
Fig. 4 is a circuit diagram showing the construction of an EXOR/EXNOR circuit which is an embodiment of the logic circuit of the present invention;
Fig. 5 is a similar view but showing the construction of a NAND/AND circuit which is another embodiment of the logic circuit of the present invention;
Fig. 6 is a circuit diagram showing the construction of an OR/NOR circuit which is a further embodiment of the logic circuit of the present invention;
Fig. 7 is a circuit diagram showing the construction of a storage circuit which is a still further embodiment of the logic circuit of the present invention;
Fig. 8 is a similar view but showing the construction of an inverted-output/positive-logic-output circuit which is a yet further embodiment of the logic circuit of the present invention; and
Fig. 9 is a circuit diagram showing the construction of a logic circuit which is formed by connecting a plurality of the logic circuits of the present invention and which has a plurality of outputs.

DETAILED DESCRIPTION OF THE PREFERRED EMBODIMENTS

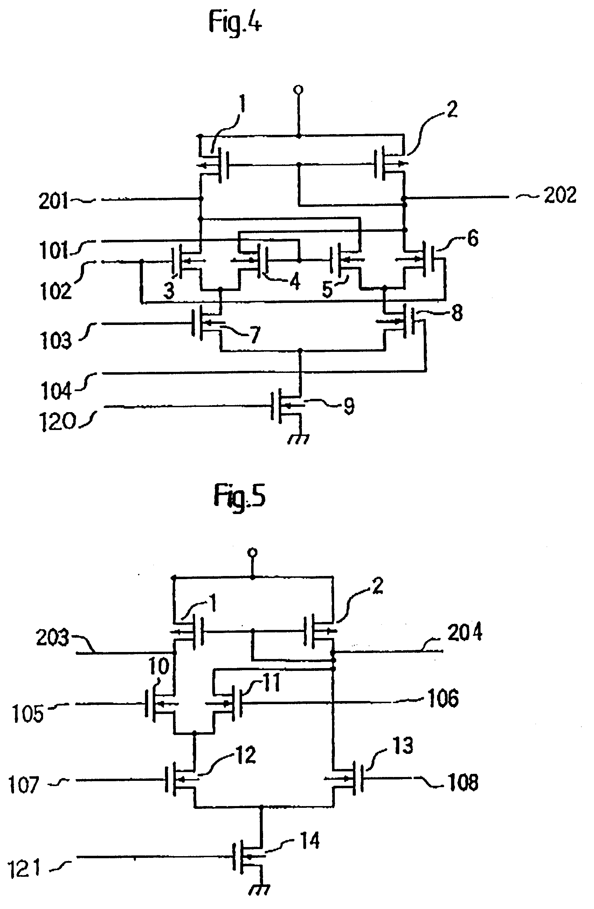

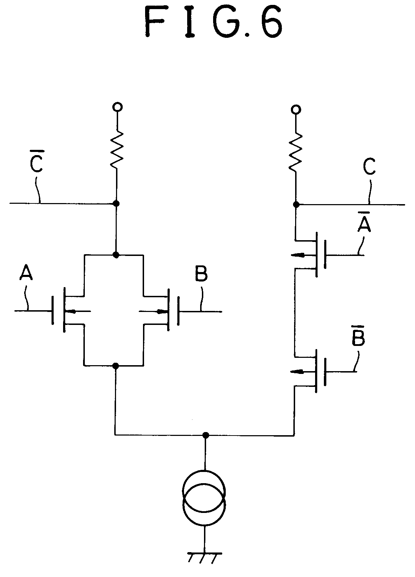

Embodiments of the present invention are next described with reference to Figs. 4 and 5.

Referring first to Fig. 4, the first embodiment of the present invention includes two p-MOS transistors 1 and 2 and seven n-MOS transistors 3, 4, 5, 6, 7, 8 and 9. p-MOS transistors 1 and 2 constitute a current mirror circuit, whose sources are connected to high potential power source $V_{DD}$. n-MOS transistor 9 is employed as the constant-current source. The gate potential of n-MOS transistor 9 is set to a potential between high potential power source $V_{DD}$ and low potential power source $G_{ND}$ through signal line 120. Now, where the constant current is represented by I and the mobility, the width of the gate, the length of the gate and the capacitance per unit area of the gate of n-MOS transistor 9 by $\mu$, W, L and $C_o$, respectively, the potential of signal line 120 is set equal to or higher than, for example,

$$\sqrt{\frac{2LI}{\mu WC_o}} \qquad (1)$$

The combinations of n-MOS transistors 3 and 4, 5 and 6, and 7 and 8 constitute three differential pair circuits and effect EXOR operation and EXNOR operation.

Operation of the present embodiment is next described.

First, two pairs of mutually inverted signals are inputted on input signal lines 101, 102 and 103, 104. For example, signal A is inputted on input signal line 102 while inverted signal A' to signal A is inputted on input signal line 101, and signal B is inputted on input signal line 103 while inverted signal B' to signal B is inputted on input signal line 104. The transistors are selectively rendered to conduct in accordance with the values of signals A and B so that an EXOR signal is outputted from output signal terminal 201 while an EXNOR signal is outputted from output signal terminal 202 as indicated below:

when A = "0" and B = "0", transistors 4, 5 and 8 conduct and output signal terminal 201 outputs "0" while output signal terminal 202 outputs "1";

when A = "0" and B = "1", transistors 4, 5 and 7 conduct and output signal terminal 201 outputs "1" while output signal terminal 202 outputs "0";

when A = "1" and B = "0", transistors 3, 6 and 8 conduct and output signal terminal 201 outputs "1" while output signal terminal 202 outputs "0"; and

when A = "1" and B = "1", transistors 3, 6 and 7 conduct and output signal terminal 201 outputs "0" while output signal terminal 202 outputs "1", where "0" represents the low voltage level, and "1" represents the high voltage level.

In the present embodiment, even if the power source voltage drops during operation, the operating current is not varied by n-MOS transistor 9 which serves as the constant-current source. Further, when the power source voltage is lowered in the design, possible deterioration of the operation speed can be avoided by making the width of the gates of p-MOS transistors 1 and 2 and of n-MOS transistor 9 wider. Furthermore, since the current which flows through the EXOR/EXNOR circuit is limited by the constant-current source, even if it is caused to operate with a high frequency in order to achieve high speed operation, the power consumption does not increase but rather remains constant. In addition, even if the current which flows through the load circuit and the constant-current source increases, high speed operation can still be achieved since the load capacitance does not increase.

While a current mirror circuit is employed as the load circuit in the present embodiment, a low resistance element may be employed instead. Further, while an n-MOS transistor is employed as the constant-current source, a p-MOS transistor may be employed instead. In this instance, however, the first power source is set to $G_{ND}$ while the second power source is set to high potential voltage level $V_{DD}$, and the potential of the gate of the p-MOS transistor serving as the constant-current source is set to a value lower than the value of $V_{DD}$ minus the value of equation (1).

Referring now to Fig. 5, the second embodiment of the present invention includes two p-MOS transistors 1 and 2 and five n-MOS transistors 10, 11, 12, 13 and 14.

p-MOS transistors 1 and 2 constitute a current mirror circuit, whose sources are connected to high potential power source $V_{DD}$. n-MOS transistor 14 is used as the constant-current source. The potential of the gate of n-MOS transistor 14 is set to a potential between high potential power source $V_{DD}$ and low potential power source $G_{ND}$ through signal line 121. Now, where the constant current is represented by I and the mobility, the width of the gate, the length of the gate and the capacitance per unit gate area of n-MOS transistor 14 by $\mu$, W, L and $C_o$, respectively, the potential of signal line 121 is set, similarly as in the first embodiment, equal to or higher than, for example,

$$\sqrt{\dfrac{2LI}{\mu W C_o}} \qquad (1)$$

The combinations of n-MOS transistors 10 and 11, and 12 and 13, constitute two differential pair circuits and effect NAND operation and AND operation.

Operation of the present embodiment is next described.

First, two pairs of mutually inverted signals are inputted on input signal lines 105, 106, 107 and 108. For example, signal A is inputted on input signal line 105 while inverted signal A' to signal A is inputted on input signal line 106, and signal B is inputted on input signal line 107 while inverted signal B' to signal B is inputted on input signal line 108. The transistors are selectively rendered to conduct in accordance with the values of signals A and B so that a NAND signal is outputted from output signal terminal 203 while an AND signal is outputted from output signal terminal 204 as indicated below:

when A = "0" and B = "0", transistors 11 and 13 conduct and output signal terminal 203 outputs "1" while output signal terminal 204 outputs "0";

when A = "0" and B = "1", transistors 11 and 12 conduct and output signal terminal 203 outputs "1" while output signal terminal 204 outputs "0";

when A = "1" and B = "0", transistors 10 and 13 conduct and output signal terminal 203 outputs "1" while output signal terminal 204 outputs "0"; and

when A = "1" and B = "1", transistors 10 and 12 conduct and output signal terminal 203 outputs "0" while output signal terminal 204 outputs "1", where "0" represents the low voltage level, and "1" represents the high voltage level.

Also in the present embodiment, even if the power source voltage drops during operation, the operating current is not varied by n-MOS transistor 14 which serves as the constant-current source. Further, when the power source voltage is lowered in the design, possible deterioration of the operation speed can be avoided by making the width of the gates of p-MOS transistors 1 and 2 and of n-MOS transistor 14 wider. Furthermore, since the current which flows through the NAND/AND circuit is limited by the constant-current source, even if it is caused to operate with a high frequency in order to achieve high speed operation, the power consumption does not increase but rather remains constant. In addition, even if the current which flows through the load circuit and the constant-current source increases, high speed operation can still be achieved since the load capacitance does not increase.

While a current mirror circuit is employed as the load circuit in the present embodiment, a low resistance element may be employed instead. Further, while an n-MOS transistor is employed as the constant-current source, a p-MOS transistor may be employed instead. In this instance, however, the first power source is set to $G_{ND}$ while the second power source is set to high potential voltage level $V_{DD}$, and the potential of the gate of the p-MOS transistor serving as the constant-current source is set to a value lower than the value of $V_{DD}$ minus the value of equation (1).

Figs. 6, 7 and 8 show the construction of an OR/NOR circuit, a storage circuit and an inverted-output/positive-logic-output circuit, respectively, which are other embodiments of the logic circuit of the present invention. Since operation of the logic circuits shown in Figs. 6 to 8 can be inferred readily on the analogy of the operation of the EXOR/EXNOR circuit or the AND/NAND circuit described in detail above, detailed descriptions thereof are omitted here. It should be noted that a low resistance element is employed as the load circuit in Figs. 6 to 8.

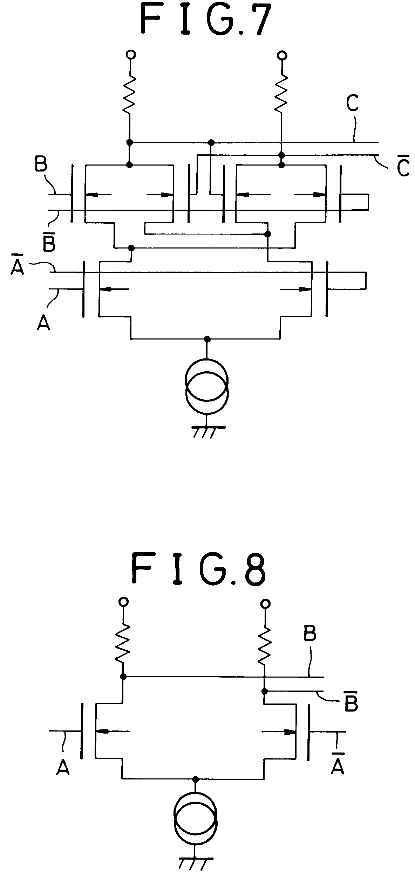

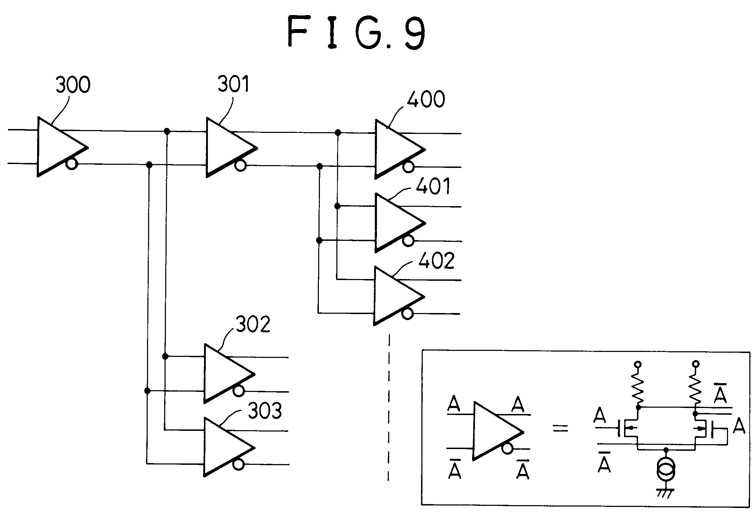

Fig. 9 illustrates the construction of an embodiment of a large-size logic circuit as defined in claim 9. Referring to Fig. 9, the two outputs of logic circuit 300 which is the inverted-output/positive-logic-output circuit shown in Fig. 8 are inputted to similar logic circuits 301, 302 and 303. Further, the two outputs of logic circuit 301 are inputted to similar logic circuits 400, 401, 402, ... while the outputs of each of logic circuit 302 and 303 are also similarly inputted to a plurality of logic circuits. The outputs of the logic circuits at the final stage can be used for a large number of loads, or alternatively, all of the outputs may be collected so as to obtain one high output.

Although certain preferred embodiments of the present invention have been shown and described in detail, it should be understood that various changes and modifications may be made therein without departing from the scope of the invention.

## Claims

1. A logic circuit, comprising a load circuit connected to a first power source, a differential pair circuit connected to said load circuit and including at least a differential pair of MOS transistors for effecting logic operation, and a constant-current source interposed between said differential pair circuit and a second power source.

2. A logic circuit as claimed in claim 1, wherein an n-MOS transistor is employed as said constant-current source and the voltage of the gate thereof is held at a fixed value between said first power source of a high potential and said second power source of a low potential which is equal to or higher than the value of

$$\sqrt{\frac{2LI}{\mu W C_O}}$$

where L is the length of the gate, I is the constant-current, $\mu$ is the mobility, W is the width of the gate and $C_o$ is the capacitance of the gate per unit area.

3. A logic circuit as claimed in claim 1, wherein a p-MOS transistor is employed as said constant-current source and the voltage of the gate thereof is held at a fixed value between said first power source of a low potential and said second power source of a high potential which is equal to or lower than the value of

$$(\text{second power source voltage level} - \sqrt{\frac{2LI}{\mu WC_o}}\ )$$

where L is the length of the gate, I is the constant-current, $\mu$ is the mobility, W is the width of the gate and Co is the capacitance of the gate per unit area.

4. A logic circuit as claimed in any one of claims 1 to 3, wherein said differential pair circuit is an EXOR/EXNOR circuit which employs MOS transistors therein.

5. A logic circuit as claimed in any one of claims 1 to 3, wherein said differential pair circuit is a NAND/AND circuit which employs MOS transistors therein.

6. A logic circuit as claimed in any one of claims 1 to 3, wherein said differential pair circuit is a NOR/OR circuit which employs MOS transistors therein.

7. A logic circuit as claimed in any one of claims 1 to 3, wherein said differential pair circuit is a storage circuit which employs MOS transistors therein.

8. A logic circuit as claimed in any one of claims 1 to 3, wherein said differential pair circuit is an inverted-output/positive-logic-output circuit which employs MOS transistors therein.

9. A logic circuit, comprising a plurality of logic circuits as defined in claim 8 and having repeated connections of such a tree structure that the inverted output signal terminal and the positive-logic-output signal terminal of the first of said logic circuits are connected to the corresponding input signal terminals of a plurality of the second of said logic circuits, and that the inverted-output signal terminal and the positive-logic-output signal terminal of each of said second logic circuits are connected to the corresponding input signal terminals of a plurality of the third of said logic circuits and so on.

# FIG.1
## (PRIOR ART)

# FIG.2
## (PRIOR ART)

# FIG.3

# Fig.4

# Fig.5

# F I G.6

EP 0 548 551 A1

# FIG.7

# FIG.8

# F I G. 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | ELECTRONICS AND COMMUNICATIONS IN JAPAN vol. 71, no. 7, July 1988, SILVER SPRING, US pages 1 - 9 , XP69955 MAEMURA ET AL 'a 1-GHz band low-power dissipation GaAs prescaler IC' * page 3, left column, line 27 - page 4, right column, line 40; figures 2,3 * | 1,7,8 | H03K19/094 H03K19/21 H03K3/356 |
| A | | 2,3 | |
| X | IEEE TRANSACTIONS ON MICROWAVE THEORY AND TECHNIQUES vol. 32, no. 1, January 1984, NEW YORK US pages 5 - 10 IDDA ET AL 'analysis of high-speed GaAs source-coupled FET logic circuits' * page 5, right column, line 1 - page 6, left column, line 9; figures 1-3 * | 1,4-6 | |
| X | PATENT ABSTRACTS OF JAPAN vol. 14, no. 546 (E-1008)4 December 1990 & JP-A-22 31 817 ( MATSUSHITA ) 13 September 1990 * abstract * | 1,8,9 | |

TECHNICAL FIELDS SEARCHED (Int. Cl.5)

H03K

The present search report has been drawn up for all claims

| Place of search | Date of completion of the search | Examiner |
|---|---|---|
| THE HAGUE | 07 APRIL 1993 | WRIGHT J.P. |

EPO FORM 1503 03.82 (P0401)